(19) 

Europäisches
Patentamt
European
Patent Office
Office européen
des brevets

(11) **EP 2 264 763 A1**

(12) # EUROPEAN PATENT APPLICATION

(43) Date of publication:
**22.12.2010 Bulletin 2010/51**

(51) Int Cl.:
***H01L 27/02*** *(2006.01)*

(21) Application number: **09162725.7**

(22) Date of filing: **15.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **IMEC**
**3001 Leuven (BE)**

(72) Inventor: **De Coster, Jeroen**
**3010, Kessel-Lo (BE)**

(74) Representative: **Hertoghe, Kris Angèle Louisa et al**
**DenK iP bvba**
**Hundelgemsesteenweg 1114**
**9820 Merelbeke (BE)**

(54) **Breakdown protection for electrostatically actuated MEMS devices**

(57)    The present invention provides a method for breakdown protection of a standalone electrostatically actuatable MEMS device provided on a chip, the MEMS device being connected via an actuation path to a signal source. The method according to embodiments of the present invention comprises providing an on-chip series resistor in the actuation path. The on-chip resistor may be, but does not need to be, the internal resistance of a signal source, which in that case also needs to be provided on-chip.

FIG. 11

EP 2 264 763 A1

**Description**

**Field of the invention**

The present invention relates generally to micromechanical devices, and more particularly to a device and method for protecting an electrostatically actuated standalone MEMS device from electrical breakdown.

**Background of the invention**

Electrostatics is the most widely used force in the design of MEMS devices. In industry, it is used in microresonators, switches, micromirrors, accelerometers, etc. The energy E that is stored in an electrostatic actuator is given by (Eq. 1):

$$E = \frac{\varepsilon_r \varepsilon_0 A V^2}{2 g_0},$$

(Eq. 1)

where $\varepsilon_r$ is the relative permittivity of the medium between the electrodes, $\varepsilon_0$ is the permittivity of vacuum, $A$ is the overlapping area of the electrodes, $V$ is the applied voltage and $g_0$ is the gap spacing between the electrodes. Different electrostatic actuation systems exist, such as for example

- parallel-plate actuation: actuation between two electrodes in which the mobile parts move along the electric field paths so as to reduce the gap spacing $g_0$;
- comb-drive actuation: lateral translation of mobile parts, leading to an increase in overlap area $A$;
- microresonators: structures not meant to translate but to vibrate, using one of the two actuation mechanisms described above.

Electrostatically actuated MEMS devices comprise a moving electrode and a stationary electrode, spaced by an air gap with thickness g. These devices are capable of transducing an electrical voltage ($V_b$) into a mechanical displacement x of the moving electrode. The 'pull-in' voltage ($V_{PI}$) is an essential characteristic of parallel-plate devices: when $V_b$ is smaller than $V_{PI}$, the displacement x will only be a fraction of the air gap g and x will vary continuously with $V_b$. If $V_b$ exceeds $V_{PI}$, the moving electrode collapses onto the stationary electrode (x=g) and will not return to its rest position until $V_b$ drops below a second threshold value, the release voltage $V_{PO}$.

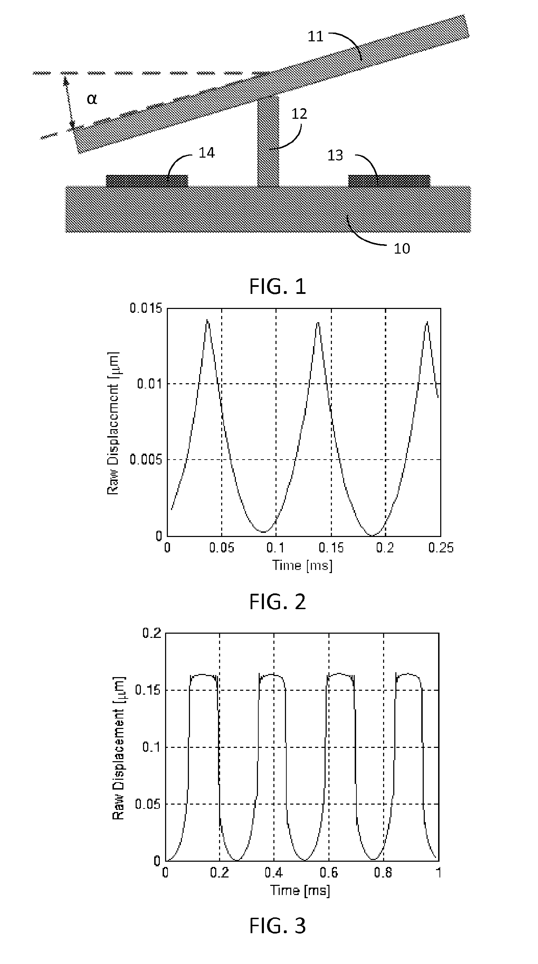

To illustrate this, FIG. 1 shows a schematic cross-section of a torsional micromirror. Such torsional micromirror may be used for example as a spatial light modulator (SLM) in an imaging system, e.g. a video display system. The torsional micromirror comprises a basis 10 and a mirror 11 movably attached via a mirror hinge 12 onto the basis 10. A first stationary bottom electrode 13 and a second stationary bottom electrode 14 are provided on the basis 10 for actuating the micromirror 11. A first and a second movable electrode (not illustrated) are provided at the bottom side of the micromirror 11, or the micromirror 11 itself forms the movable electrodes, in a position above the first and second stationary electrodes 13 and 14. By actuation of the stationary electrodes 13, 14, e.g. by applying a suitable DC voltage signal between any of the stationary bottom electrodes 13, 14, and the mirror 11, the mirror 11 is deflected or tilted, e.g. attracted towards one of the stationary electrodes 13, 14, as the mirror 11 and the bottom electrodes 13, 14 form capacitors. The angle of deflection is called the tilt angle $\alpha$ and can for example be measured by scanning across the mirror 11 with a laser-Doppler vibrometer. Once the electrostatic force between the mirror 11 and the static electrodes 13, 14 is removed, the energy stored in the mirror hinge 12 provides a restoring force to return the mirror 11 to an untilted position.

For optimal operation of a torsional micromirror, it should promptly return to its untilted (equilibrium) position when so desired. However, in some cases the micromirror may get stuck in its tilted position and not return to the untilted position, although no attraction generating actuation signal is applied.

When the voltage between the mirror 11 (movable electrode) and the bottom electrode 13, 14 is a bipolar triangular waveform with a frequency $\omega$ that is well below the mechanical resonance frequency $\omega_0$ of the device, and with an amplitude $V_b$ that is below the pull-in voltage $V_{PI}$, a displacement waveform similar to the one shown in FIG. 2 is obtained. The mirror 11 never enters into physical contact with any of the bottom electrodes 13, 14. If the amplitude $V_b$ of the actuation voltage is higher than the pull-in voltage $V_{PI}$, the mirror 11 does make physical contact with the bottom electrodes 13, 14 and a displacement waveform similar to the one shown in FIG. 3 is obtained.

If no dielectric is present between the stationary electrodes 13, 14 and the moving electrode, application of a voltage $V_b > V_{PI}$ will result in a direct contact of two conducting surfaces that bear a different electrical voltage. As a result, the contact may break down and welding may occur, thus destroying the device as it gets stuck in the contact position and never returns to its initial position. Whether or not this welding occurs, depends e.g. on the presence of a native oxide and the amplitude value $V_b$ of the actuation signal.

Current limiting in the down position of the mirror 11 can help resolve the problem; however, no satisfying solutions exist, as described below.

Three common situations where voltages $V_b > V_{PI}$ can be present at the device terminals are described below:

1. Test equipment

1.a. Current limiting by source

If one desires to test an electrostatic actuator 40 with voltages higher than $V_{PI}$, one would typically use test equipment, e.g. a test signal generator 41 with a built-in current compliance (e.g. a parameter analyzer or a DC bias source). This is described for example by Strong et al., in "Electrical discharge across micrometer-scale gaps for planar MEMS structures in air at atmospheric pressure", J. Micromech. Microeng. 18(2008) 075025. However, the inventors found this method to be ineffective.

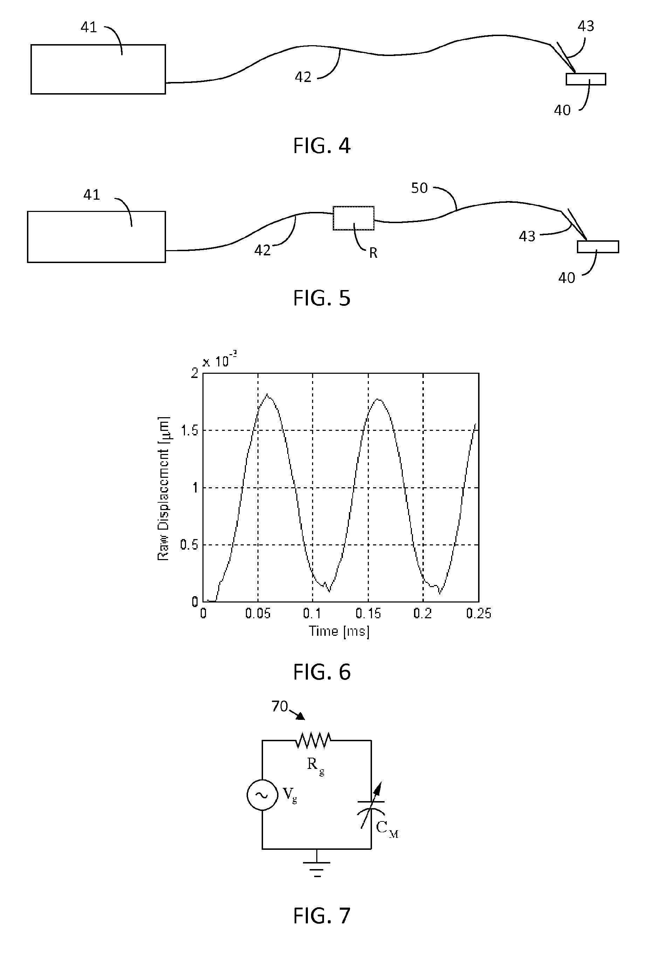

A typical case is illustrated in FIG. 4. The device under test (DUT) 40 is connected to the test equipment, e.g. test signal generator 41 using a length of coax cable 42 and a probe 43. When the device 40 starts breaking down, e.g. because a first and a second electrodes thereof are in physical contact, a current starts flowing through the probe 43 and the coax cable 42, and a current compliance limit of the test signal generator 41 is triggered. However, if the RC time constant of the system comprising test signal generator 41 and coax cable 42 is higher than the RC time constant of the DUT 40, current limiting by the test signal generator 41 will be ineffective and the coax cable 42 will discharge into the DUT 40 which may get irreversibly welded in the down position as a consequence.

Hence current limiting by the source is ineffective. As a result, some other, improved, means of protecting the DUT 40 during test is required.

1.b. Current limiting by series resistance

Another method of protecting the DUT 40 comprises a low-pass filter that is integrated at some point between the test signal generator 41 and the DUT 40. In its most simple form, a low-pass filter can be made using a single capacitor and a resistor. For instance, a low-pass filter could be inserted in the actuation path by inserting a series resistor R in the setup from FIG. 4 as shown in FIG. 5, i.e. at the end of the coax cable 42 a resistor R is provided, which is then connected via a further coax cable 50 to the probe 43.

Together with the capacitance C of the further coax cable 50, the series resistor R forms a low pass filter. This is illustrated by comparison of the measurements illustrated in FIG. 2 and FIG. 6. FIG. 2 shows the measured response of a device 40 to a 10kHz triangular waveform with R=0. The DUT 40 is connected via a 1m long coax cable 42 to a test signal generator 41. Inserting a 1MOhm series resistor R and a coax cable 50 of also approximately 1m long (C = 100pF/m) causes the displacement of the mirror 11 to drop from 13.5nm (FIG. 2) to less than 2nm (FIG. 6).

The above illustrates that a simple current-limiting resistor along the path between test signal generating source 41 and DUT 40 is ineffective for protecting a device 40 against electrical overstress: the functional behaviour of the device 40 is affected to such an extent that it cannot fulfil its desired function anymore.

2. Normal device operation

Also during normal operation, one can think of situations where it is desired to operate beyond pull-in electrostatic actuators without dielectric. Example: RF MEMS switches or relays without dielectric, micromirrors in some imaging applications... Omitting the dielectric may be beneficial from a reliability point of view. In those cases, the native oxide that serves as a barrier between the contacting electrodes is a weak point that needs protection.

3. Electrostatic discharge events

During ESD events, a certain amount of charge is injected rapidly (tens of ns) at the device terminals. Since electrostatic actuators are intrinsically high-impedance devices, the charge accumulates and results in a relatively long electrical overstress of the device (several ms). During this overstress, the device has enough time to respond mechanically and to pull in. If enough charge is still present at this point in time, the contact can break down which results in permanent welding of the contact.

## Summary of the invention

It is an object of embodiments of the present invention to provide a method to reduce the failure threshold of electrostatic actuators while still preserving the desired functionality of the device.

The above objective is accomplished by a method and device according to the present invention.

In a first aspect, the present invention provides a method for breakdown protection of a standalone electrostatically actuatable MEMS device provided on a chip, the MEMS device being connected via an actuation path to a signal source. The method according to embodiments of the present invention comprises providing an on-chip series resistor in the actuation path. The on-chip resistor may be the internal resistance of a signal source, which in that case also needs to be provided on-chip.

A method according to embodiments of the present invention may furthermore comprise providing an on-chip charge-buffering shunt capacitor.

A method according to embodiments of the present invention may comprise measuring the intrinsic mechanical resonance frequency of the MEMS device, determining the desired operational frequency of the MEMS device, and if the desired operational frequency of the MEMS device is smaller than the intrinsic mechanical resonance frequency of the MEMS device, selecting the resistance value of the on-chip series resistor and/or the capacitance value of an on-chip charge-buffering shunt capacitor such that the mechanical resonance frequency of a combination of MEMS device, on-chip series resistor and optionally buffering shunt capacitor is reduced, but remains above the desired operational frequency of the MEMS device.

The method according to embodiments of the present invention relies on increasing the electrical RC time constant of the MEMS electrostatic actuator to a level above the electrical RC time constant of the combined source and interconnection.

In a second aspect, the present invention provides a breakdown protection circuit for a standalone electrostatically actuatable MEMS device provided on a chip, the electrostatically actuatable MEMS device being adapted for being connected via an actuation path to a signal source (Vg), the protection circuit comprising an on-chip series resistor for being connected in the actuation path. In particular embodiments of a breakdown protection circuit according to the present invention, the on-chip series resistor may be an internal resistance of the signal source which is placed on-chip.

The on-chip series resistor may be such that it is able to limit the current in case breakdown of the MEMS device occurs.

A breakdown protection circuit according to embodiments of the present invention may furthermore comprise an on-chip charge- buffering shunt capacitor. The shunt capacitor may be such that it limits the voltage amplitude seen by the MEMS device coupled thereto. A capacitance value of the shunt capacitor may be selected such that it offers additional protection against breakdown at little cost, e.g. a deviation of less than 10%, preferably less than 5%, more preferably less than 1%, in terms of switching time of the MEMS device.

In a breakdown protection circuit according to embodiments of the present invention, the shunt capacitor and the series resistor may b such that they increase the electrical RC time constant of a MEMS device coupled thereto to a level above the electrical RC time constant of a system comprising a signal generator and its interconnection as connected to the electrostatically actuatable MEMS device.

In a breakdown protection circuit according to embodiments of the present invention, the on-chip series resistor may be a lumped resistor adjacent to the MEMS device. In alternative embodiments, the on-chip series resistor may be formed by a dielectric, for example, but not limited thereto, a silicon nitride layer, or tantalum oxide, or even a polymer. In particular embodiments, the dielectric is a thick dielectric. In yet alternative embodiments, the on-chip series resistor may be formed by a passivation layer on top of an electrode. In still other embodiments, the MEMS device may be formed from a highly resistive material, thus forming the on-chip series resistor. In such embodiments, the resistivity of e.g. SiGe used for forming the MEMS device could be tuned towards higher values for application in electrostatic actuators.

In a third aspect, the present invention provides a breakdown protection circuit as in any of the embodiments of the second aspect, implemented in a circuit comprising a MEMS device, a signal generator and a communication link between the signal generator and the MEMS device. The signal generator may be an on-chip signal generator. The signal generator may be implemented on the same chip as the one where the MEMS device is implemented.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

**Brief description of the drawings**

FIG. 1 shows a schematic cross-section of a torsional micromirror.

FIG. 2 is a graph illustrating measured displacement when actuating a mirror with a triangular waveform, for the case of $V_b << V_{PI}$ and $\omega << \omega_0$.

FIG. 3 is a graph illustrating measured displacement when actuating a mirror with a triangular waveform, for the case of $V_b > V_{PI}$ and $\omega << \omega_0$.

FIG.4 illustrates a test set-up where the DUT is being probed and connected to a generator through a pre-determined length of coax cable.

FIG. 5 illustrates a test set-up where the DUT is being probed and connected to a generator through two pre-determined lengths of coax cable in between which a single resistor R is inserted, thus forming a low-pass filter with the capacitance C of the coax cables.

FIG. 6 illustrates a test set-up where the DUT is being probed and connected to a generator through two pre-determined lengths of coax cable provided with a series resistor in between, as illustrated in FIG. 5.

FIG. 7 is a schematic illustration of a MEMS capacitor $C_M$ connected to a bias source $V_g$ through a series resistor $R_g$.

FIG. 8 is a SEM image of an embodiment of a circuit as schematically illustrated in FIG. 7.

FIG. 9 illustrates (top) measured displacement of a suspended electrode during an HBM ESD discharge, for different values of a series resistor $R_g$, and (bottom) the applied HBM waveform.

FIG. 10 is a schematic cross-section of a parallel-plate actuator with a curved top electrode.

FIG. 11 is an electrical circuit according to embodiments of the present invention, comprising a MEMS device along with a bias source, a series resistor, a fixed shunt capacitor and substrate components.

FIG.12 shows an implementation of a MEMS device with a fixed on-chip shunt capacitor.

FIG. 13 illustrates a measured and a simulated step response of the device illustrated in FIG. 7, with an on-chip resistance $R_g$ = 1 M$\Omega$, measured at P = 0.1 mbar.

FIG. 14 illustrates a measured and a simulated step response of the device illustrated in FIG. 7, with an on-chip resistance $R_g$ = 1M$\Omega$, a substrate capacitance $C_s$=50pF and a substrate resistance $R_s$ = 5 M$\Omega$, measured at P = 0.1 mbar.

FIG. 15 illustrates simulated and a measured switching time $t_{on}$ as a function of the shunt capacitance $C_p$.

FIG. 16 is an image of an example of a micromirror device.

FIG. 17 illustrates a measured frequency response of the micromirror device of FIG. 16.

FIG. 18 illustrates the response of a scanning mirror as in FIG. 16 to a 10 kHz triangular waveform, in case the series resistance $R_g$ = 0$\Omega$ (top) and in case the series resistance $R_g$ = 1M$\Omega$ (bottom).

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

**Detailed description of illustrative embodiments**

The example below uses a torsional microplate as illustrated in FIG. 1 as a test vehicle in order to illustrate the method and device according to embodiments of the present invention. This, however, is not intended to be limiting for the present invention. A recent development in the field of electromechanics has been the miniaturisation of various mechanical devices. Typical of such devices are tiny gears, levers and valves. These "micro-mechanical" devices are manufactured using integrated circuit techniques, often together with electrical control circuitry. Common applications include accelerometers, pressure sensors and actuators. As another example, spatial light modulators can be configured from micro-mechanical reflective mirror elements.

In case MEMS devices are processed on a CMOS substrate, protection of the MEMS device against electrical overstress (EOS) and electrostatic discharge (ESD) can be taken care of by classical ESD protection structures in the underlying CMOS. However, in general MEMS devices are relatively large devices, and CMOS is an expensive process. If only limited driver space is necessary for implementing a CMOS driver for driving the MEMS device, it is not necessary to use an expensive CMOS substrate, and the MEMS device can be implemented "stand alone" on a cheap substrate. If a MEMS device is fabricated in such a stand-alone manner, the above classical ESD protection structures cannot be implemented and protection devices are needed that can be integrated in the MEMS process itself. This excludes 'active' devices like diodes and transistors. As a result, embodiments of the present invention rely purely on 'passive' components, i.e. resistors and capacitors.

According to a first embodiment of the present invention, a breakdown protection circuit is provided for a standalone MEMS device on a chip, the MEMS device being adapted for electrostatic actuation. The MEMS device is adapted for being connected via an actuation path, e.g. a coax cable, to a signal generator. The breakdown protection circuit comprises an on-chip series resistor for being connected in the actuation path.

A schematic illustration of such protection circuit 70 is provided in FIG. 7. The MEMS device is illustrated by a MEMS capacitor $C_M$. The MEMS device $C_M$ is connected to a bias source $V_g$ through an on-chip series resistor $R_g$. If the bias source $V_g$ is implemented on-chip, the on-chip series resistor $R_g$ can be the internal resistance of the bias source $V_g$. In alternative embodiments of the present invention, if the bias source $V_g$ is not implemented on-chip, a supplementary on-chip series resistor $R_g$ is provided. In embodiments of the present invention, the parasitic capacitance between the on-chip series resistance $R_g$ and the MEMS device $C_M$ should be kept to a minimum.

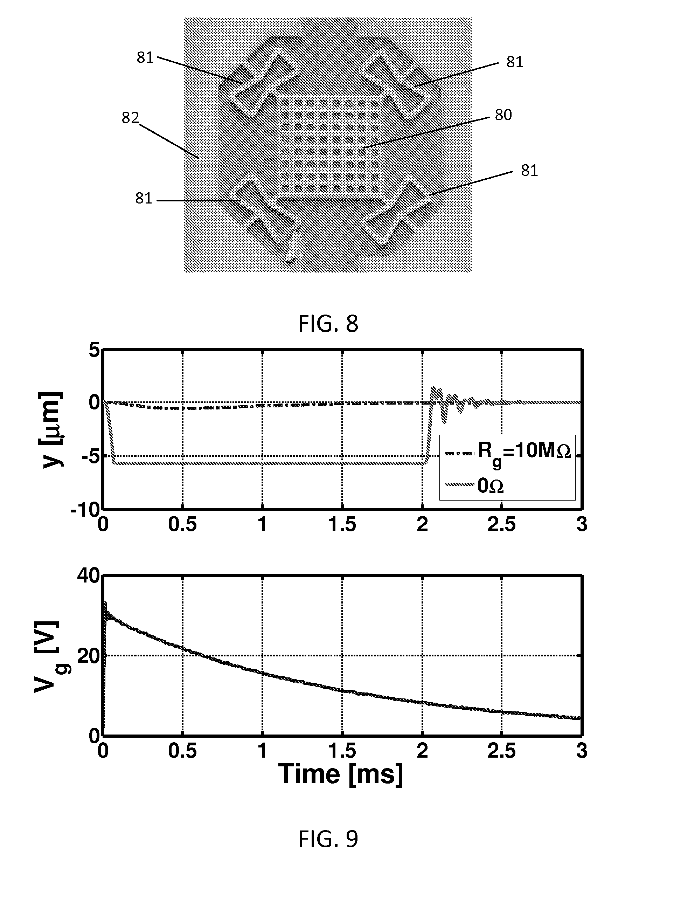

A SEM image of a possible implementation of a MEMS device with a protection circuit as in accordance with embodiments of the present invention is shown in FIG. 8. A fixed electrode (not illustrated in the drawing) is provided underneath a square movable top electrode 80. This moveable electrode 80 is attached at each of its corners by means of a spring 81 to a substrate 82. On this specific device, the on-chip series resistance is not illustrated.

Current limiting

The influence of the on-chip series resistance $R_g$ in accordance with embodiments of the present invention on EOS/ESD robustness was verified by measuring the mechanical response to HBM (Human Body Model) ESD pulses of electrostatic parallel-plate actuators as the one shown in FIG. 8. The top graph of FIG. 9 shows the measured displacement y of the suspended top electrode 80 when applying 30 V pulses as in the bottom graph of FIG. 9 for different series resistances $R_g$. The top electrode 80 is pulled in as a consequence of the ESD event if the series resistance $R_g$ = 0 Ω, whereas a very low displacement is seen for a series resistance $R_g$ = 10 MΩ.

ESD pulses with increasing amplitude were then delivered to the devices up to the point of failure. For a series resistance $R_g$=0Ω, damage occurred at 80 V. For a series resistance $R_g$ = 1MΩ, no damage was observed even at 200 V. Hence current limiting by means of the on-chip series resistor $R_g$ prevents catastrophic failure of the device.

Not only for HBM discharges, but also for DC overstress does the series resistance $R_g$ increase the failure threshold. This was verified by applying a slow bias ramp voltage to test devices with a suspended SiGe electrode as well as a fixed SiGe bottom electrode. The current through the devices was measured so as to detect the failure level. For a series resistance $R_g$ = 0 Ω, the SiGe-SiGe interface broke down at 21 V, whereas this value increased to 34 V for a series resistance $R_g$ = 1 MΩ.

Effect of current limiting on functional behaviour

The effect of the on-chip current-limiting resistor $R_g$ in accordance with embodiments of the present invention on the functional behaviour of MEMS devices is studied. Two operating regimes are distinguished. In case of switching devices, the switching time is studied. In case of vibrating or resonating devices, the influence of $R_g$ on the bandwidth is studied.

*Switching*

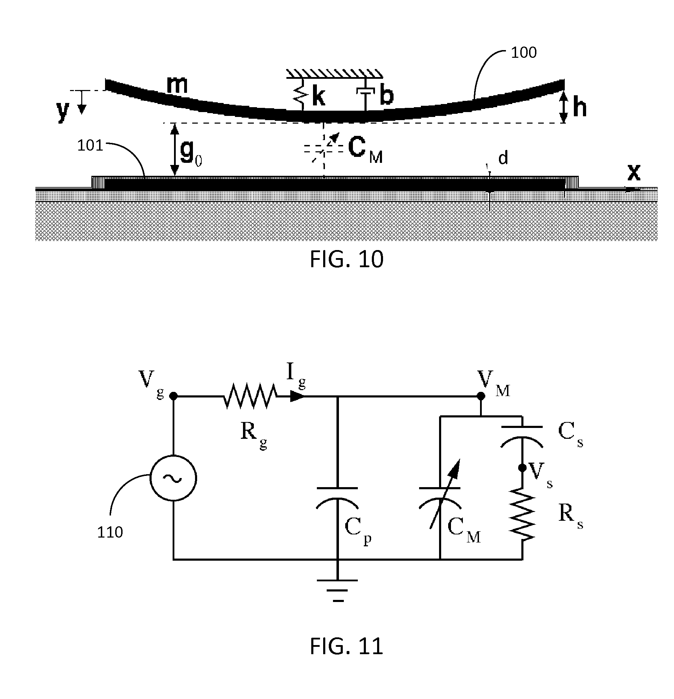

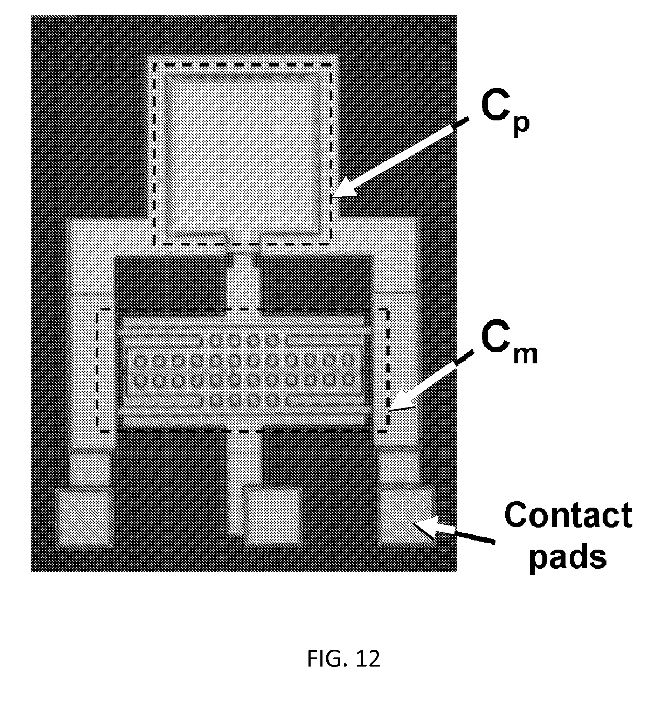

FIG.10 depicts a schematic cross-section of a MEMS device with a curved top electrode 100. The amount of curvature h and its effect on the electrostatic force will be taken into account in the analysis below. FIG. 11 on the other hand, represents the electrical equivalent circuit of the MEMS device $C_M$ together with the bias source $V_g$, a current limiting on-chip series resistor $R_g$ in accordance with embodiments of the present invention, as well as a fixed capacitor $C_p$ and the elements $C_s$ and $R_s$ representing the substrate. The substrate is represented by a resistive value $R_s$ and a capacitive value $C_s$ coupled in series. This substrate impedance is coupled in parallel to the MEMS device capacitance $C_M$. A shunt capacitance $C_p$ is added in parallel to study its effect on the switching time. These parallel coupled elements are coupled in series to an on-chip resistance $R_g$ (not illustrated in FIG. 12). FIG. 12 illustrates an implementation of a MEMS device with a fixed on-chip shunt capacitor $C_p$.

The dynamic behaviour of electrostatically actuated MEMS devices has been studied in the past from different perspectives, such as: undamped response, the effect of (air) damping, tailoring bias waveforms, electrical damping using a source resistance. As demonstrated hereinabove, the on-chip series resistance $R_g$ can be used to improve the robustness against EOS/ESD. But at the same time, increasing the on-chip series resistance $R_g$ will adversely affect the dynamic response.

As can be understood from FIG. 11, the substrate parasitics $R_s$, $C_s$ are not expected to affect switching transients if the on-chip series resistance $R_g$ = 0 Ω. Also in case the substrate parasitic $R_s C_s \rightarrow 0$ or $R_s C_s \rightarrow \infty$, the substrate does not play a significant role. The latter case occurs for instance if glass or quartz is used as substrate material.

On the contrary, depending on the dimensions of the MEMS device and the substrate material, $C_s$ and $R_s$ can significantly influence the dynamic behaviour of the system if large values of the on-chip series resistance $R_g$ are used: generating a step voltage with the bias source $V_g$ will cause the substrate capacitance $C_s$ to be charged through the on-chip series resistance $R_g$ and the substrate resistance $R_s$, resulting in a voltage drop over the series resistance $R_g$. As a result, the MEMS device $C_M$ will not see the source voltage $V_g$ across its terminals until the substrate capacitance $C_s$ is charged. Since the time constant $(R_g+R_s)C_s$ can be orders of magnitude larger than the time constant $R_g(C_M+C_p)$, this may considerably slow down switching times. The system of differential equations (Eq.2) describes the mechanical motion (FIG. 10) as well as the electrical transients (FIG. 11) that govern the closure of the device:

$$\begin{cases} m\ddot{y} + b\dot{y} + ky = F_e \\ \dfrac{\partial V_M}{\partial t} = \dfrac{1}{C_M + C_p}\left(\dfrac{V_g - V_M}{R_g} - \dfrac{V_M - V_s}{R_s}\right) \\ \dfrac{\partial V_s}{\partial t} = \dfrac{V_M - V_s}{R_s C_s} \end{cases}$$

$$(Eq.2)$$

where m is the mass of the moving electrode 100,

    y is the measured displacement of the suspended top electrode,
    b is the damping coefficient of the system,
    k is the suspension's spring constant,
    $F_e$ is the electrostatic force applied to the suspended top electrode, and
    the symbols that refer to electrical quantities are indicated in FIG. 11.

Solving these equations yields the position y of the top electrode 100 as a function of time if a step voltage is applied to the system. The electrostatic force in an electrostatically actuated MEMS device with a curved top electrode 100 is given by equation (Eq.3):

$$F_e = \frac{\varepsilon_0 A V_M^2}{4\left(g_0 - y + \frac{d}{\varepsilon_r}\right)^2}\left(\frac{arctan(H)}{H} + \frac{1}{1+H^2}\right)$$

$$(Eq.3)$$

$$C_M = \frac{\varepsilon_0 A}{\sqrt{Gh}} arctan(H)$$

$$H = \sqrt{\frac{h}{G}}$$

$$G = g_0 - y + \frac{d}{\varepsilon_r}$$

where A is the area of the suspended electrode 100,

$g_0$ is the minimum distance between the bottom electrode 101 and the suspended electrode 100,

h is the deflection or curvature of the suspended electrode 100,

y is the displacement distance of the suspended electrode 100, which may vary, at the edge of the switch, between 0 (up-state) and $g_0$+h (down state),

d is the thickness of the dielectric,

$g_0$ is the zero-voltage gap spacing of the switch as illustrated in FIG. 10,

$\varepsilon_0$ is the dielectric constant of air,

$\varepsilon_r$ is the dielectric constant of the medium present between the bottom electrode 101 and the suspended electrode 100.

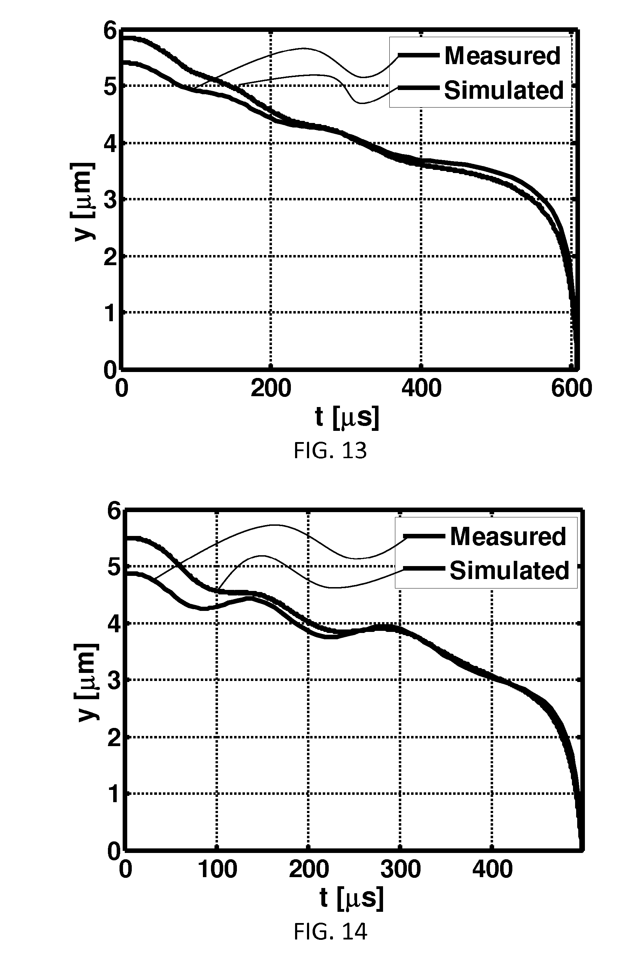

In (Eq.3), the curvature of the top electrode 100 is approximated by a parabolic shape in one dimension. Curvature is added in the equations since the tested devices (cf. FIG. 8) had a considerable topography, with $h \approx 1\mu m$ and $g_0 \approx 5 \mu m$. The results obtained by solving the above equations are compared to optical measurements using a laser Doppler vibrometer (LDV). For the case where the on-chip series resistance $R_g$ = 1 MΩ, FIG. 13 shows both the simulated and measured step response.

The initial voltage drop over the on-chip series resistance $R_g$ as the generator 110 is switched on can be approximated as:

$$V_g - V_M = \frac{R_g V_g}{R_s + R_g} \rightarrow V_M = \frac{R_s}{R_s + R_g} V_g \qquad (Eq.4)$$

If for the voltage $V_g$ applied by the generator 110 it holds that $V_g < V_{PI} (R_s + R_g)/R_g$, then the MEMS device will initially move to an intermediate stable position. If the device is under-damped (which was the case for the measurement shown in FIG.13, as the atmospheric pressure was reduced to 0.1 mbar), the device displays a damped oscillating motion at its natural frequency around this intermediate position. As the substrate capacitance $C_s$ is being charged, the voltage $V_M$ over the MEMS device approaches the voltage $V_g$ applied by the generator 110. When the voltage $V_M$ over the MEMS device becomes larger than the pull-in voltage $V_{PI}$, $V_M > V_{PI}$, the MEMS device will pull in.

The pull-in trajectory that is followed by the top electrode 100 is affected by both the substrate resistance $R_s$ and the substrate capacitance $C_s$. This is illustrated in FIG. 14, where a measurement on the same device as in FIG. 13 is shown, but with a lumped substrate capacitance $C_s$ = 50 pF and substrate resistance $R_s$ = 5 MΩ added artificially. The oscillation of the top electrode 100 now has larger amplitude (compare FIG. 14 to FIG. 13).

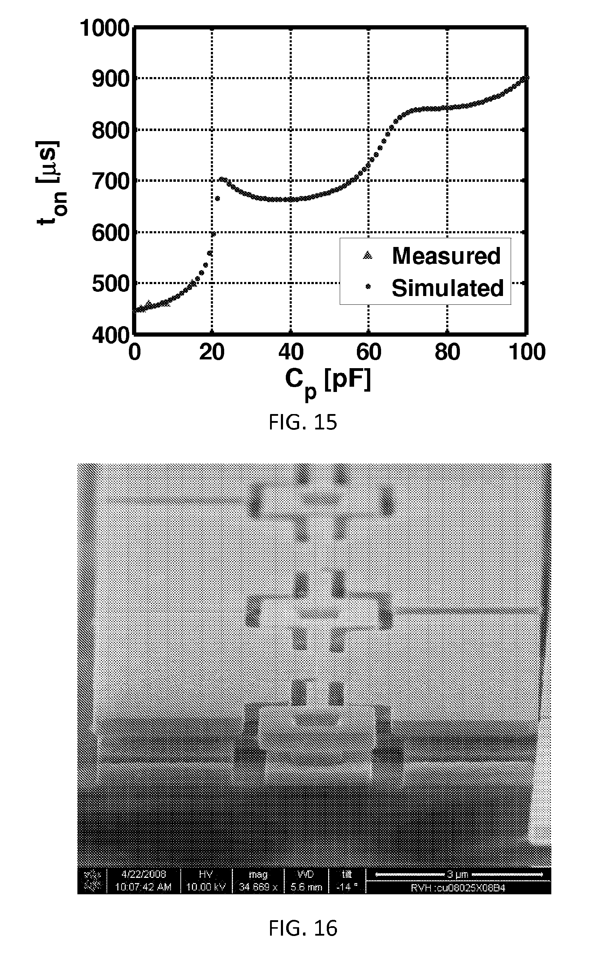

The value of the on-chip capacitance $C_p$ (FIG. 11) interferes with the oscillation that is caused by the presence of the current limiting on-chip series resistance $R_g$, the substrate resistance $R_s$ and the substrate capacitance $C_s$: the on-chip shunt capacitor $C_p$ can slightly shift the instant at which the pull-in threshold is reached. Depending on whether this instant coincides with a maximum or a minimum of the free oscillation, the total pull-in time will be shortened or lengthened by the on-chip capacitance $C_p$. When an electrical voltage step is applied, two things happen simultaneously. The voltage $V_M$ over the MEMS device $C_M$ has an RC response, i.e. evolves asymptotically towards a steady-state value. As the voltage $V_M$ over the MEMS device $C_M$ increases, the switch can start oscillating (cf. FIG. 13 and FIG. 14). How these two events are synchronised depends on the value of $C_p$. For some values of $C_p$, $V_M$ will first exceed the pull-in voltage $V_{PI}$ at a moment where the displacement $y$ has a local maximum. For other values of $C_p$, this will happen at a moment where the displacement $y$ has a local minimum. This results in the characteristic of FIG. 15, i.e. the switching time does not increase monotonously with $C_p$. The figure indicates that, under the bias conditions used during the measurements, one could increase the on-chip shunt capacitance $C_p$ from 20 pF to 60 pF without or substantially without increasing the switching time $t_{on}$. At the same time, increasing the on-chip shunt capacitance $C_p$ will reduce the voltage amplitude seen across the MEMS device's terminals during an ESD event. From the measurement values as illustrated in the graph of FIG. 15 it is possible to select a capacitance value for $C_p$ which is an optimal trade-off between switching time (the lower the better, hence the lower $C_p$ the better) and the voltage amplitude seen across the MEMS device's terminals during an ESD event (the lower the better, hence the higher $C_p$ the better).

In conclusion, in case of switches, the substrate parameters were found to give rise to oscillations of the MEMS device under certain conditions. In turn, these oscillations may interfere with parasitic capacitances (interconnections, bond pads) giving rise to local minima and maxima in the switching time. With an on-chip 1MΩ series resistor as protection, the failure threshold could be raised from 80V to 200V for a switch with a static pull-in voltage $V_{PI}$ of 10V, an airgap $g_0$ of 3$\mu$m and an actuation area A $\approx 2 \cdot 10^5$ $\mu m^2$.

*Resonance or vibration*

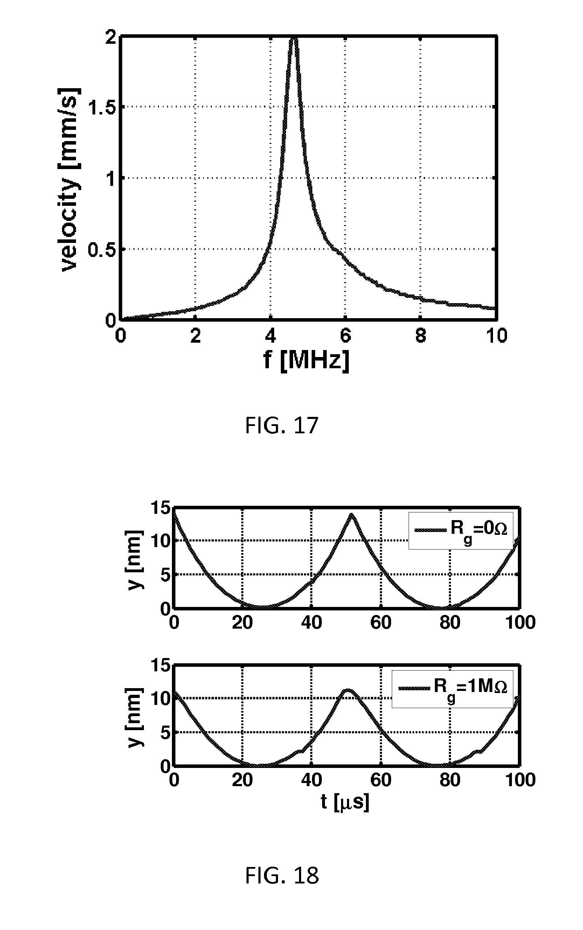

The torsional micromirror shown in FIG.16 can be represented by the same equivalent circuit as illustrated in FIG. 11, but this time the source voltage $V_g$ is a harmonic signal in the kHz range and with an amplitude below the pull-in voltage $V_{PI}$. FIG. 17 shows the intrinsic bandwidth of the device, which in this specific case is in the MHz range Since the combination of the on-chip series resistor $R_g$ and the on-chip shunt capacitance $C_p$, $R_g \cdot C_p$, acts as a low-pass filter, the effective operational bandwidth of the device will be lowered. The on-chip series resistor $R_g$ must hence be dimensioned such that the responsiveness of the MEMS device during normal operation, e.g. between 0 and 10 kHz, is preserved, while still maintaining some degree of protection against overvoltage.

FIG. 18 shows the response of the mirror to a 10kHz triangular waveform. The top graph of the figure illustrates measurements for a prior art set-up with on-chip resistance $R_g$ = 0 Ω. The response to the same waveform if the on-chip resistance $R_g$ = 1 MΩ according to embodiments of the present invention, is given in the bottom graph. Given that the capacitance $C_M$ of the micromirror itself is typically fairly small (~10 fF), one would expect the cut-off frequency fc of the combination $R_g \cdot C_M$ to be around 16 MHz, as fc = 1/(2*pi*$R_g$*$C_M$) ≈ 16 MHz, and hence one would not expect any difference between the responses shown in FIG. 18 (top) and (bottom). Due to the presence of on-chip parasitic capacitances $C_p$ in the bond pads and interconnections though, the combination $R_g(C_M+C_p)$ has a much lower cut off frequency, for example 0.5 MHz for a Cp value of a few tenths of pF, e.g. 0.3pF - however, this number strongly depends on the design and layout of the device, bondpads, substrate material, .... This is visible in the response from the bottom part of FIG. 18: the displacement peaks are truncated for $R_g$ = 1 MΩ.

In conclusion, for devices that operate with a harmonic oscillation, it was shown that mechanical bandwidth can be traded in against improved robustness. With the same 1MΩ series resistor as used above, the operating bandwidth of a torsional micromirror is reduced to 10kHz, but the failure threshold rises from 20V to 40V for a $8\mu m x 8\mu m$ mirror with static pull-in voltage of 15V.

In essence, a method according to embodiments of the present invention comprises placing a series resistor $R_g$ and optionally a charge-buffering shunt capacitor $C_p$ (the charge-buffering shunt capacitor may be formed by on-chip parasitic of e.g. the bond pads) in the actuation path. The purpose of these components is to:

- limit the current in case breakdown occurs,
- limit the voltage amplitude seen by the MEMS device by increasing capacitance, and
- increase the electrical RC time constant of the MEMS electrostatic actuator to a level above the RC time constant of the source + interconnection.

A method according to embodiments of the present invention therefore may comprise the following steps:

1. Measuring the intrinsic mechanical resonance frequency $\omega_0$ of the device,
2. Determining the desired operational frequency $\omega$ of the device,
3. if $\omega < \omega_0$ the excess mechanical bandwidth can be traded in against improved robustness against electrical overstress. This is accomplished by incorporating a low-pass filter into the actuation path. However, in order to obtain a sufficiently large operational bandwidth (unlike the result shown in FIG. 6) this low-pass filter is implemented on-chip. The resistor $R_g$ limits the current, while the capacitor $C_p$ stores a limited amount of charge. As charge flows towards the capacitor $C_p$ through the current limiting resistor $R_g$, the voltage $V_M$ seen by the MEMS device and hence the acceleration of the moving electrode is affected.

In an experiment with a MEMS device with torsional microplate, the intrinsic mechanical resonance frequency $\omega_0$ of the MEMS device was higher than 2MHz whereas the desired operating frequency was only 6kHz. In other words, the intrinsic mechanical resonance frequency of the electrostatically actuated MEMS device is far higher than the used frequency. This means that, in accordance with embodiments of the present invention, the frequency may be limited artificially by electrical means without compromising the functional behaviour of the device. For test purposes this was done in two different implementations:

- With a 1 MΩ resistor provided at the end of the wiring near the chip, the functional behaviour was not affected up to 50kHz, while the failure threshold rises from 20V to 35V.
- With an on-chip resistor, the ESD failure threshold rises from 40V to 400V. Functional behaviour up to 10kHz remains unaffected.

Rather than implementing the resistor as a lumped element, one could use a high-resistivity material, for example SiGe, for manufacturing the electrostatic actuator, which then gains some degree of intrinsic immunity against electrical overstress.

While the invention has been illustrated and described in detail in the drawings and foregoing description, such illustration and description are to be considered illustrative or exemplary and not restrictive. The invention is not limited to the disclosed embodiments.

For example, it is possible to operate the invention in an embodiment wherein the MEMS device is another type of electrostatically driven MEMS actuator, e.g. resonators with high bias voltage, RF switches, accelerometers, gyroscopes, ...

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to include any specific characteristics of the features or aspects of the invention with which that terminology is associated.

**Claims**

1.    A method for breakdown protection of a standalone electrostatically actuatable MEMS device ($C_M$) provided on a chip, the MEMS device ($C_M$) being connected via an actuation path to a signal source ($V_g$), the method comprising providing an on-chip series resistor ($R_g$) in the actuation path.

2.    A method according to claim 1, wherein providing an on-chip series resistor in the actuation path comprises providing the signal source ($V_g$) with its source resistance on-chip.

3.    A method according to any of the previous claims, furthermore comprising providing an on-chip charge-buffering shunt capacitor ($C_p$).

4.    A method according to any of the previous claims, comprising
measuring the intrinsic mechanical resonance frequency ($\omega_0$) of the MEMS device ($C_M$), determining the desired operational frequency ($\omega$) of the MEMS device ($C_M$), and
if the desired operational frequency ($\omega$) of the MEMS device ($C_M$) is smaller than the intrinsic mechanical resonance frequency ($\omega_0$) of the MEMS device ($C_M$), selecting the resistance value of the on-chip series resistor ($R_g$) and/or the capacitance value of the on-chip charge-buffering shunt capacitor ($C_p$) such that the mechanical resonance frequency of a combination of MEMS device, series resistor ($R_g$) and optionally buffering shunt capacitor ($C_p$) is reduced, but remains above the desired operational frequency ($\omega$) of the MEMS device ($C_M$).

5.    A breakdown protection circuit for a standalone electrostatically actuatable MEMS device ($C_M$) provided on a chip, the electrostatically actuatable MEMS device ($C_M$) being adapted for being connected via an actuation path to a signal source ($V_g$), the protection circuit comprising
an on-chip series resistor ($R_g$) for being connected in the actuation path.

6.    A breakdown protection circuit according to claim 5, wherein the on-chip series resistor ($R_g$) is the internal resistance of the signal source ($V_g$) which is placed on-chip.

7.    A breakdown protection circuit according to any of claims 5 or 6, wherein the on-chip series resistor ($R_g$) is such that it is able to limit the current in case breakdown of the MEMS device ($C_M$) occurs.

8.    A breakdown protection circuit according to any of claims 5 to 7, furthermore comprising an on-chip charge- buffering shunt capacitor ($C_p$).

9.    A breakdown protection circuit according to claim 8, wherein the shunt capacitor ($C_p$) is such that it limits the voltage amplitude seen by the MEMS device ($C_M$) coupled thereto.

10. A breakdown protection circuit according to any of claims 8 or 9, wherein a value of the shunt capacitor ($C_p$) is selected such that it offers additional protection against breakdown at little cost in terms of switching time of the MEMS device ($C_M$).

11. A breakdown protection circuit according to any of claims 5 to 10, wherein the on-chip series resistor ($R_g$) is a lumped resistor adjacent to the MEMS device ($C_M$).

12. A breakdown protection circuit according to any of claims 5 to 10, wherein the on-chip series resistor ($R_g$) is formed by a dielectric.

13. A breakdown protection circuit according to any of claims 5 to 10, wherein the on-chip series resistor ($R_g$) is formed by a passivation layer on top of an electrode.

14. A breakdown protection circuit according to any of claims 5 to 10, wherein the MEMS device ($C_M$) is formed from a highly resistive material thus forming the on-chip series resistor ($R_g$).

15. A breakdown protection circuit according to any of claims 5 to 14, implemented in a circuit comprising a MEMS device ($C_M$), a signal generator ($V_g$) and a communication link between the signal generator ($V_g$) and the MEMS device ($C_M$).

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

Europäisches
Patentamt

European
Patent Office

Office européen
des brevets

# EUROPEAN SEARCH REPORT

Application Number

EP 09 16 2725

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 023 329 A (QUALCOMM MEMS TECHNOLOGIES INC [US]) 11 February 2009 (2009-02-11) * abstract * * paragraphs [0036] - [0038] * | 1,5,7, 11,15 | INV. H01L27/02 |
| Y | | 14 | |
| A | | 2-4,6, 8-10,12, 13 | |
| X | DE 10 2007 029874 A1 (ROHDE & SCHWARZ [DE]) 4 December 2008 (2008-12-04) * abstract * * paragraphs [0007], [0012], [0019] * * figure 2 * | 1-13,15 | |
| X | WO 2006/007042 A (NORTHROP GRUMMAN CORP [US]; NATHANSON HARVEY C [US]; KIRBY CHRISTOPHER) 19 January 2006 (2006-01-19) * paragraphs [0032] - [0039] * * figures 8-10 * | 1,2,5-8, 11,15 | |
| A | | 3,4,9, 10,12-14 | TECHNICAL FIELDS SEARCHED (IPC) |
| Y | EP 1 884 974 A (SEIKO EPSON CORP [JP]) 6 February 2008 (2008-02-06) * abstract * * paragraphs [0008], [0045], [0048], [0055], [0057], [0064] * * figure 1 * | 14 | H01H H02H H01L |
| A | | 1-13,15 | |

-/--

The present search report has been drawn up for all claims

| Place of search | Date of completion of the search | Examiner |
|---|---|---|
| Berlin | 26 August 2009 | Morena, Enrico |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt
European
Patent Office
Office européen
des brevets

**EUROPEAN SEARCH REPORT**

Application Number

EP 09 16 2725

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CAILLARD B ET AL: "Electrical overstress/electrostatic discharges (EOS/ESD) specificities in MEMS: outline of a protection strategy" PROCEEDINGS OF THE 14TH INTERNATIONAL SYMPOSIUM ON THE PHYSICAL & FAILURE ANALYSIS OF INTEGRATED CIRCUITS IPFA 2007 IEEE PISCATAWAY, NJ, USA, July 2007 (2007-07), pages 107-111, XP002543000 ISBN: 1-4244-1014-2 * the whole document * | 1-15 | |
| A | SANGAMESWARAN S ET AL: "ESD reliability issues in microelectromechanical systems (MEMS): a case study on micromirrors" PROCEEDINGS OF THE 30TH EOS/ESD DISCHARGE SYMPOSIUM 2008, 7 September 2008 (2008-09-07), - 12 September 2008 (2008-09-12) pages 3B.1-1-3B.1-9, XP002543004 Piscataway, NJ, USA * the whole document * | 1-15 | TECHNICAL FIELDS SEARCHED (IPC) |

The present search report has been drawn up for all claims

| Place of search | Date of completion of the search | Examiner |
|---|---|---|
| Berlin | 26 August 2009 | Morena, Enrico |

EPO FORM 1503 03.82 (P04C01)

EP 2 264 763 A1

**ANNEX TO THE EUROPEAN SEARCH REPORT
ON EUROPEAN PATENT APPLICATION NO.**

EP 09 16 2725

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2009

| Patent document cited in search report | | Publication date | Patent family member(s) | | Publication date |
|---|---|---|---|---|---|
| EP 2023329 | A | 11-02-2009 | EP | 2023330 A1 | 11-02-2009 |
| | | | US | 2009040136 A1 | 12-02-2009 |
| | | | WO | 2009020882 A1 | 12-02-2009 |
| DE 102007029874 | A1 | 04-12-2008 | NONE | | |
| WO 2006007042 | A | 19-01-2006 | US | 7102472 B1 | 05-09-2006 |
| EP 1884974 | A | 06-02-2008 | CN | 101118819 A | 06-02-2008 |
| | | | JP | 4265630 B2 | 20-05-2009 |
| | | | JP | 2008041378 A | 21-02-2008 |
| | | | KR | 20080012787 A | 12-02-2008 |
| | | | US | 2008035458 A1 | 14-02-2008 |

EPO FORM P0459

For more details about this annex : see Official Journal of the European Patent Office, No. 12/82

22